# EUROPEAN PATENT APPLICATION

(11) **EP 4 845 354 A1**
(43) Date of publication of application: **25.11.2026**
(21) Application number: 25853351.2
(22) Date of filing: 09.01.2025
(51) Int. Cl.: H10F 77/20

(54) **SOLAR CELL, CELL STRING, CELL ASSEMBLY, AND PHOTOVOLTAIC SYSTEM**

(30) Priority: 12.08.2024 CN 202411105279
(71) Applicant: Zhuhai Fushan Aiko Solar Energy Technology Co., Ltd., FushanIndustrial Park, Doumen District Zhuhai Guangdong 519000 (CN); Guangdong Aiko Solar Energy Technology Co., Ltd., Foshan, Guangdong 528000 (CN); Zhejiang Aiko Solar Energy Technology Co., Ltd., Yiwu, Jinhua Zhejiang 322000 (CN); Tianjin Aiko Solar Energy Technology Co., Ltd., Tianjin 300400 (CN)
(72) Inventor: WANG, Yongqian, Jinhua, Zhejiang 322000 (CN); YANG, Xinqiang, Jinhua, Zhejiang 322000 (CN); CHEN, Gang, Jinhua, Zhejiang 322000 (CN)
(74) Representative: EP&C
(86) International application number: PCT/CN2025/071617
(87) International publication number: WO 2026/036645

(57) **Abstract**

The present disclosure is applicable to the technical field of solar cells, and provides a solar cell, a cell string, a cell module and a photovoltaic system. The solar cell includes a cell substrate, first fine grids, second fine grids, current collecting structures and first bending structures. The current collecting structures are disposed on the cell substrate. The first fine grids are at least partially connected to the current collecting structures. The first bending structures are connected to the first fine grids and the current collecting structures. The first bending structures extend along a first direction and are at least partially bent in a second direction. A width of portions where the current collecting structures are in contact with the first bending structures in the second direction is greater than that of the first fine grids in the second direction. As such, the first fine grids are connected to the current collecting structures via the first bending structures, such that the current collecting structures have a certain movement allowance in a plane of the cell substrate. The width of the portions where the first bending structures are in contact with the current collecting structures in the second direction is greater than that of the first fine grids in the second direction, which further improves the connection stability.

## Description

### CROSS-REFERENCE TO RELATED APPLICATIONS

The present disclosure claims the priority of Chinese patent application entitled "Solar Cell, Cell String, Cell Module and Photovoltaic System" submitted on August 12, 2024, with the application number of 202411105279.X, which is incorporated herein by reference in its entirety.

### TECHNICAL FIELD

The present disclosure pertains to the technical field of solar cells, and particularly relates to a solar cell, a cell string, a cell module and a photovoltaic system.

### BACKGROUND

At present, a solar cell is a semiconductor device directly converting energy of sunlight into electric energy. The solar cell uses the photovoltaic effect to excite electrons by absorbing photons and export the electrons to generate electric currents through a built-in electric field. In this case, grid lines can collect and transmit the electric currents, thereby converting light energy into the electrical energy. However, in related arts, the stress concentration tends to occur at joints between the grid lines and pads. The grid lines are generally broken at the joints when the pads are disposed or during lamination.

### SUMMARY

Embodiments of the present disclosure provide a solar cell, a cell string, a cell module and a photovoltaic system, aiming to solve the problem that fine grids and pads are easy to disconnect in processes of fabricating and using a photovoltaic cell.

An embodiment of the present disclosure provides a solar cell. The solar cell includes a cell substrate, first fine grids, second fine grids, current collecting structures and first bending structures. The first fine grids are disposed on the cell substrate and extend along a first direction. The second fine grids are disposed on the cell substrate. The first fine grids and the second fine grids are distributed along a second direction. The current collecting structures are disposed on the cell substrate. The first fine grids are at least partially connected to the current collecting structures. The first bending structures are connected to the first fine grids and the current collecting structures. The first bending structures extend along the first direction and are at least partially bent in the second direction. A width of portions where the current collecting structures are in contact with the first bending structures in the second direction is greater than that of the first fine grids in the second direction.

In the solar cell according to embodiments of the present disclosure, the solar cell includes the cell substrate, the first fine grids, the second fine grids, the current collecting structures and the first bending structures. The first fine grids are disposed on the cell substrate and extend along the first direction. The second fine grids are disposed on the cell substrate. The first fine grids and the second fine grids are distributed along the second direction. The current collecting structures are disposed on the cell substrate. The first fine grids are at least partially connected to the current collecting structures. The first bending structures are connected to the first fine grids and the current collecting structures. The first bending structures extend along the first direction and are at least partially bent in the second direction. The width of the portions where the current collecting structures are in contact with the first bending structures in the second direction is greater than that of the first fine grids in the second direction. As such, the first fine grids are connected to the current collecting structures via the first bending structures, such that the current collecting structures have a certain movement allowance in a plane of the cell substrate. The first bending structures can change elastically when solder strips are connected to the current collecting structures, so as to ensure the connection stability. Moreover, the width of the portions where the first bending structures are in contact with the current collecting structures in the second direction is greater than that of the first fine grids in the second direction, which further improves the connection stability and prevent the first fine grids from being broken due to the stress concentration.

In some embodiments, the first bending structures have a maximum bending distance of 100µm to 400µm relative to the first fine grids in the second direction.

In some embodiments, the second bending structures have a height of 35µm to 200µm in a third direction, wherein the third direction is perpendicular to the first direction and the second direction.

In some embodiments, the solar cell further includes second fine grids and third fine grids arranged on the cell substrate, wherein the second fine grids, the first fine grids and the third fine grids extend along the first direction and are distributed along the second direction, and the second fine grids and the third fine grids are adjacent to the first fine grids in the second direction; and
the first bending structures include first bending sections and second bending sections, wherein the first bending sections are bent relative to the first fine grids in a direction of being close to the second fine grids, and the second bending sections are bent relative to the first fine grids in a direction of being close to the third fine grids.

In some embodiments, the maximum bending distance of the first bending structures relative to the first fine grids in the second direction is less than a distance between the first fine grids and the second fine grids; and
a maximum bending distance of the second bending structures relative to the first fine grids in the second direction is less than a distance between the first fine grids and the third fine grids.

In some embodiments, a plurality of the first bending structures and a plurality of the second bending sections are disposed alternately along the first direction.

In some embodiments, the first bending structures are undulated.

In some embodiments, the solar cell further includes busbars disposed on the cell substrate, wherein the current collecting structures are formed on the busbars, and a plurality of the busbars extend along the second direction and are distributed along the first direction; and
the first fine grids are connected to the busbars or the current collecting structures; and
the second fine grids and the third fine grids are disconnected at the busbars.

In some embodiments, the solar cell further includes second bending structures, wherein the second bending structures are connected to the busbars and the current collecting structures, and the second bending structures extend along the second direction and are at least partially bent in the first direction.

In some embodiments, the second bending structures have a maximum bending distance of 100µm to 400µm relative to the busbars in the first direction; and
the second bending structures have a height of 35µm to 200µm in the third direction, wherein the third direction is perpendicular to the first direction and the second direction.

The cell string provided in embodiments of the present disclosure includes the solar cell as described in any of the above embodiments.

The cell module provided in embodiments of the present disclosure includes the cell string as described in the above embodiments.

The photovoltaic system provided in embodiments of the present disclosure includes the cell module as described in the above embodiments.

In the solar cell, the cell string, the cell module and the photovoltaic system according to embodiments of the present disclosure, the solar cell includes the cell substrate, the first fine grids, the second fine grids, the current collecting structures and the first bending structures. The first fine grids are disposed on the cell substrate and extend along the first direction. The second fine grids are disposed on the cell substrate. The first fine grids and the second fine grids are distributed along the second direction. The current collecting structures are disposed on the cell substrate. The first fine grids are at least partially connected to the current collecting structures. The first bending structures are connected to the first fine grids and the current collecting structures. The first bending structures extend along the first direction and are at least partially bent in the second direction. The width of the portions where the current collecting structures are in contact with the first bending structures in the second direction is greater than that of the first fine grids in the second direction. As such, the first fine grids are connected to the current collecting structures via the first bending structures, such that the current collecting structures have a certain movement allowance in a plane of the cell substrate. The first bending structures can change elastically when solder strips are connected to the current collecting structures, so as to ensure the connection stability. Moreover, the width of the portions where the first bending structures are in contact with the current collecting structures in the second direction is greater than that of the first fine grids in the second direction, which further improves the connection stability and prevent the first fine grids from being broken due to the stress concentration.

### BRIEF DESCRIPTION OF DRAWINGS

Fig. 1 is a schematic diagram showing a partial structure of a solar cell according to an embodiment of the present disclosure;
Fig. 2 is a schematic diagram showing another partial structure of a solar cell according to an embodiment of the present disclosure;
Fig. 3 is a schematic diagram showing a further partial structure of a solar cell according to an embodiment of the present disclosure;
Fig. 4 is a schematic diagram showing a further partial structure of a solar cell according to an embodiment of the present disclosure;
Fig. 5 is a schematic diagram showing a further partial structure of a solar cell according to an embodiment of the present disclosure;
Fig. 6 is a schematic diagram showing a modular structure of a cell string according to an embodiment of the present disclosure;
Fig. 7 is a schematic diagram showing a modular structure of a cell module according to an embodiment of the present disclosure; and
Fig. 8 is a schematic diagram showing a modular structure of a photovoltaic system according to an embodiment of the present disclosure.

### Description of reference symbols of main components:

100: solar cell; 10: cell substrate; 20: first fine grid; 30: second fine grid; 40: third fine grid; 50: current collecting structure; 60: first bending structure; 61: first bending section; 62: second bending section; 70: busbars; 80: second bending structure; 200: cell string; 300: cell module; and 400: photovoltaic system.

### DETAILED DESCRIPTION OF EMBODIMENTS

In order to make the objectives, technical solutions and advantages of the present disclosure clearer, the present disclosure will be further described in detail below with reference to accompanying drawings and embodiments. Examples of embodiments described herein are shown in the accompanying drawings, in which the same or similar reference symbols denote the same or similar elements or elements having the same or similar functions throughout. embodiments described below with reference to the accompanying drawings are exemplary, are provided merely for the purpose of illustrating the present disclosure, and should not be construed as a limitation to the present disclosure. Further, it should be understood that the specific embodiments described herein are merely used for describing the present disclosure rather than limiting the present disclosure.

In the description of the present disclosure, it should be understood that orientational or positional relationships indicated by terms such as "length", "width", "upper", "lower", "left", "right", "horizontal", "top" and "bottom" are based on orientational or positional relationships shown in the accompanying drawings, are only for the purpose of facilitating the description of the present disclosure and simplifying the description, but are not intended to indicate or imply that the apparatus or component referred to must have a particular orientation or be constructed and operated in a particular orientation. Therefore, such terms should not be construed as a limitation to the present disclosure.

In addition, terms "first" and "second" are used for a descriptive purpose only and should not be construed as indicating or implying relative importance or implying a quantity of technical features indicated. Thereby, a feature defined by "first" or "second" may explicitly or implicitly include one or more of such features. In the description of the present disclosure, "a plurality of" means two or more, unless otherwise explicitly and particularly defined.

In the description of the present disclosure, it should be noted that, unless otherwise explicitly specified or defined, terms such as "install", "connect" and "connection" shall be construed broadly. For example, they may be a fixed connection, a detachable connection, or an integral connection; they may be a mechanical connection, an electrical connection or a mutual communication; and they can be a direct connection or an indirect connection via an intermediate medium, and they can be an internal communication between two components or an interaction relationship between the two components. Specific meanings of the above terms in the present disclosure may be understood depending on specific circumstances for those ordinarily skilled in the art.

In the present disclosure, unless otherwise expressly specified or defined, a first feature being "on" or "under" a second feature may involve the first feature being in contact with the second feature, or the first feature is not in direct contact with the second feature but rather is in contact with the second feature through a further feature therebetween. Moreover, the first feature being "on", "above", and "over" the second feature involves the first feature being directly above and obliquely above the second feature, or simply indicates that the first feature is horizontally higher than the second feature. The first feature being "under", "below" and "underneath" the second feature involves the first feature being directly below and obliquely below the second feature, or simply indicates that the first feature is horizontally lower than the second feature.

The description below provides a number of different embodiments or examples to implement different structures of the present disclosure. In order to simplify the description of the present disclosure, parts and settings of specific examples will be described below. Certainly, they are only examples and are not intended to limit the present disclosure. In addition, reference numbers and/or reference letters may be repeated in different examples of the present disclosure, and such a repetition is for the purposes of simplification and clarity and does not in itself indicate the relationship between various embodiments and/or settings in question. Further, although the present disclosure provides examples of various specific processes and materials, applications of other processes and/or use scenarios of other materials can occur in those ordinarily skilled in the art.

In related arts, the solar cell uses the photovoltaic effect to excite electrons by absorbing photons and export the electrons to generate an electric current through a built-in electric field. However, the stress concentration tends to occur at joints between the grid lines and pads, and the grid lines generally tend to break at the joints when the pads are disposed or during the lamination. In embodiments of the present disclosure, the first fine grids are connected to the current collecting structures via the first bending structures, such that the current collecting structures have a certain movement allowance in a plane of the cell substrate. The first bending structures can change elastically when solder strips are connected to the current collecting structures, so as to ensure the connection stability. Moreover, a width of portions where the first bending structures are in contact with the current collecting structures in the second direction is greater than that of the first fine grids in the second direction, which further improves the connection stability and prevent the first fine grids from being broken due to the stress concentration.

### Embodiment 1

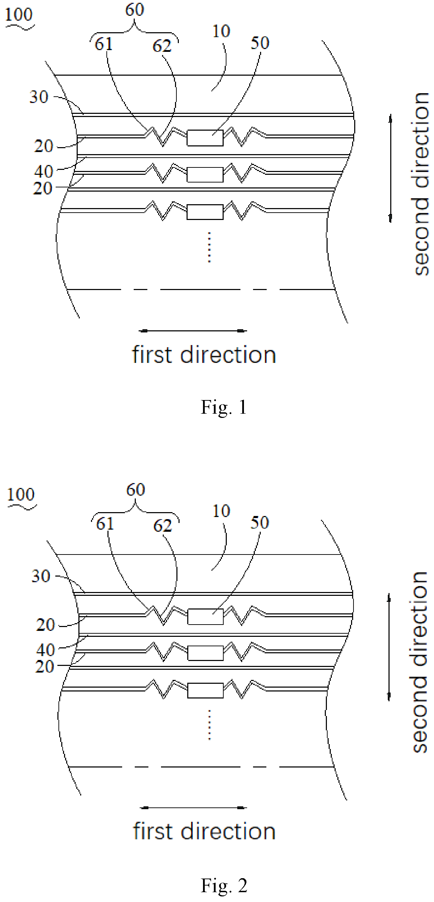

Referring to Fig. 1, Fig. 2 and Fig. 3, an embodiment of the present disclosure provides a solar cell 100. The solar cell 100 includes a cell substrate 10, first fine grids 20, second fine grids 30, current collecting structures 50 and first bending structures 60. The first fine grids 20 are disposed on the cell substrate 10 and extend along a first direction. The second fine grids 30 are disposed on the cell substrate 10. The first fine grids 20 and the second fine grids 30 are disposed along a second direction. The current collecting structures 50 are disposed on the cell substrate 10. The first fine grids 20 are at least partially connected to the current collecting structures 50. The first bending structures 60 are connected to the first fine grids 20 and the current collecting structures 50. The first bending structures 60 extend along the first direction and are at least partially bent in the second direction. A width of portions where the current collecting structures 50 are in contact with the first bending structures 60 in the second direction is greater than that of the first fine grids 20 in the second direction.

In the solar cell 100 according to embodiments of the present disclosure, the solar cell 100 includes the cell substrate 10, the first fine grids 20, the second fine grids 30, the current collecting structures 50 and the first bending structures 60. The first fine grids 20 are disposed on the cell substrate 10 and extend along a first direction. The second fine grids 30 are disposed on the cell substrate 10. The first fine grids 20 and the second fine grids 30 are disposed along a second direction. The current collecting structures 50 are disposed on the cell substrate 10. The first fine grids 20 are at least partially connected to the current collecting structures 50. The first bending structures 60 are connected to the first fine grids 20 and the current collecting structures 50. The first bending structures 60 extend along the first direction and are at least partially bent in the second direction. The width of the portions where the current collecting structures 50 are in contact with the first bending structures 60 in the second direction is greater than that of the first fine grids 20 in the second direction. As such, the first fine grids 20 are connected to the current collecting structures 50 via the first bending structures 60, such that the current collecting structures 50 have a certain movement allowance in a plane of the cell substrate 10. The first bending structures 60 can change elastically when solder strips are connected to the current collecting structures 50, so as to ensure the connection stability. Moreover, the width of the portions where the first bending structures 60 are in contact with the current collecting structures 50 in the second direction is greater than that of the first fine grids 20 in the second direction, which further improves the connection stability and prevent the first fine grids 20 from being broken due to the stress concentration.

Particularly, the first fine grids 20 are connected to the current collecting structures 50 via the first bending structures 60, such that the current collecting structures 50 have a certain movement allowance in a plane of the cell substrate 10. That is to say, when the current collecting structures 50 move slightly relative to the cell substrate 10, the first bending structures 60 can be pulled to change elastically to move slightly, so as to avoid the disconnection of the first fine grids 20 from the current collecting structures 50 in a fabricating process and improve the connection stability.

Further, in the second direction, a width of the current collecting structures 50 is greater than that of the first bending structures 60 and the first fine grids 20. The first bending structures 60 are bent vertically relative to the first fine grids 20 in the second direction. That is to say, the first bending structures 60 have a certain gradient with respect to the first fine grids 20. In this way, the width of the portions where the current collecting structures are in contact with the first bending structures 60 in the second direction is greater than that of the first fine grids 20 in the second direction. The first bending structures 60 and the current collecting structures 50 have a large connection area, which can improve the connection stability between the first bending structures 60 and the current collecting structures 50, eliminate the problem of the stress concentration, and prevent the first fine grids 20 from being broken due to the stress concentration.

It should be understood that when the first fine grids 20, the current collecting structures 50 and the first bending structures 60 are disposed on the cell substrate 10, relative positions of the first fine grids 20, the current collecting structures 50 and the first bending structures 60 with respect to the cell substrates 10 remain unchanged. However, the stress concentration generally occurs in a process of connecting the current collecting structures 50 with the solder strips, such that the current collecting structures 50 tend to move relative to the first fine grids 20, while the first bending structures 60 at least partially have a gradient with respect to the first fine grids 20 and are connected to the current collecting structures 50, and can slightly move with the current collecting structures 50. In this way, the first bending structures 60 move slightly for a very short distance relative to the cell substrate 10, which can eliminate the problem of the stress concentration. Moreover, the first bending structures 60 and the current collecting structures 50 have a large connection area, which can effectively reduce the tensile pressure and further avoid the problem of the stress concentration.

In some embodiments, the first bending structures 60 effectively disperse the stress and reduces the risk of breaking the fine grids during the soldering and lamination of the cell substrate 10, thereby improving the overall reliability and the service life of the solar cell 100. Accordingly, the mechanical property of the solar cell 100 is improved, the electrical performance of the solar cell 100 is enhanced, and higher power generation efficiency and longer service life are ensured.

In embodiments of the present disclosure, polarities of the first fine grids 20 and the second fine grids 30 have no restrictions, and polarities between the first fine grids 20 and the second fine grids 30 are reversed to meet different needs. Exemplarily, the first fine grids 20 are positive grid lines. The second fine grids 30 are negative grid lines. The first fine grids 20 can be connected to the current collecting structures 50. The current collecting structures 50 can be connected to the solder strips to connect an external load, so as to generate the electricity. The solder strips can be connected to the plurality of current collecting structures 50, such that electric currents of the plurality of first fine grids 20 are collected. Certainly, the first fine grids 20 can be negative grid lines, and the second fine grids 30 can be positive grid lines.

It should be understood that "first" and "second" in the first fine grids 20 and the second fine grids 30 refer to relative concepts, indicating that the two grid lines are different.

In addition, in embodiments of the present disclosure, a specific material type of the first bending structures 60 has no restrictions to meet different needs. In one example, the first bending structures 60 can be a part of the current collecting structures 50. That is to say, the first bending structures 60 are fabricated while the current collecting structures 50 are fabricated on the cell substrate 10. The first bending structures 60 are fabricated from the same material as the current collecting structures 50. When the current collecting structures 50 are fabricated from a solder paste, the first bending structures 60 can be fabricated from the solder paste, which further improves the connection stability between the first bending structures 60 and the current collecting structures 50. In another example, the first bending structures 60 can be a part of the first fine grids 20. That is to say, the first bending structures 60 are fabricated while the first fine grids 20 are fabricated on the cell substrate 10. The first bending structures 60 are fabricated from the same material as the first fine grids 20.

In this embodiment, the solar cell 100 can be a cell plate without busbars, and the fine grids directly conduct the electric currents to the solder strips through the current collecting structures 50, and the solder strips conduct the electric currents to an external load to generate the electricity.

In addition, in embodiments of the present disclosure, a correspondence relationship between the first fine grids 20 and the first bending structures 60 is not defined. For example, a part of the first fine grids 20 is not connected to the current collecting structures 50, such that no first bending structures 60 are disposed on ends of the part of the first fine grids 20 to meet different needs.

In some embodiments, the first bending structures 60 may be selectively disposed on ends of a part of the first fine grids 20, and no first bending structures 60 are disposed on ends of the other part of the first fine grids 20. In further embodiments, one ends of the first fine grids 20 can be provided with the first bending structures 60 while the other ends thereof can be provided with no first bending structures 60. In further embodiments, two ends of each of the first fine grids 20 can be both provided with the first bending structures 60.

### Embodiment 2

Referring to Fig. 1 and Fig. 2, in some alternate embodiments, the first bending structures 60 have a maximum bending distance of 100µm to 400µm relative to the first fine grids 20 in the second direction. For example, the maximum bending distance of the first bending structures 60 relative to the first fine grids 20 in the second direction can be 100µm, 110µm, 120µm, 130µm, 140µm, 150µm, 160µm, 170µm, 180µm, 190µm, 200µm, 210µm, 220µm, 230µm, 240µm, 250µm, 260µm, 270µm, 280µm, 290µm, 300µm, 310µm, 320µm, 330µm, 340µm, 350µm, 360µm, 370µm, 380µm, 390µm, 400µm.

As such, the maximum bending distance of the first bending structures 60 relative to the first fine grids in the second direction is set within such a range, which can ensure that the current collecting structures 50 have a movement allowance, and prevent the current collecting structures 50 from being disconnected from the first bending structures 60 and the first bending structures 60 from influencing further fine grids.

Exemplarily, the maximum bending distance of the first bending structures 60 relative to the first fine grids 20 in the second direction can be 200µm, which can ensure that the current collecting structures 50 have a sufficient movement allowance, and prevent the current collecting structures 50 from being disconnected from the first bending structures 60 due to a stress or an external force and the first bending structures 60 from interfering or influencing adjacent fine grids effectively.

Further, it is necessary to solder the solder strips and the current collecting structures 50 together in the fabricating process, thereby enabling the solder strips to be connected to the plurality of first fine grids 20 to collect the electric currents. However, the problem of the stress concentration generally occurs in the process of connecting the solder strips with the current collecting structures 50, or even joints between the first fine grids 20 and the current collecting structures 50 are broken or damaged. However, the current collecting structures 50 of embodiments of the present disclosure can be connected to the first fine grids 20 via the first bending structures 60, which ensures the flexibility and adaptability of the current collecting structures 50 on the cell substrate 10 and improves the connection stability between the first fine grids 20 and the current collecting structures 50. In this way, by reasonably controlling the bending distance of the first bending structures 60, the mechanical strength and flexibility of the joints between the first bending structures 60 and the current collecting structures 50 can be better controlled, such that the reliability in welding and use processes is improved, and the service life of the solar cell 100 is prolonged.

Certainly, a spacing between the first fine grids 20 and the second fine grids 30 should be greater than the maximum bending distance of the first bending structures 60 relative to the first fine grids 20 in the second direction, so as to avoid the problem of short circuit.

### Embodiment 3

Referring to Fig. 1 and Fig. 2, in some alternate embodiments, the first bending structures 60 have a height of 35µm to 200µm in a third direction, wherein the third direction is perpendicular to the first direction and the second direction. For example, a height of the first bending structure 60 in the third direction can be 35µm, 40µm, 50µm, 60µm, 70µm, 80µm, 90µm, 100µm, 110µm, 120µm, 130µm, 140µm, 150µm, 160µm, 170µm, 180µm, 190µm, 200µm.

As such, the height of the first bending structures 60 relative to the cell substrate 10 in the third direction is set within such a range, which can not only ensure the connection stability between the first fine grids 20 and the current collecting structures 50, and but also avoid affecting the thickness of the cell module 300 due to large height of the first bending structures 60.

Exemplarily, the height of the first bending structures 60 in the third direction can be 80µm, and the first bending structures 60 are set at this height, which can not only ensure the connection stability between the first fine grids 20 and the current collecting structures 50, but also avoid affecting the overall thickness of the cell module 300 due to large height of the first bending structures 60.

Further, the height of the first fine grids 20 in the third direction can range 35µm to 200µm. The heights of the first fine grids 20 and the first bending structures 60 in the third direction can be the same, which ensures the connection stability between the first fine grids 20 and the first bending structures 60. In this embodiment, the heights of the first fine grids 20 and the first bending structures 60 in the third direction can be 80µm, which can minimize the influence on the thickness of the cell module 300 while ensuring the reliability of the mechanical connection, and help optimize the overall performance and appearance of the cell module 300.

### Embodiment 4

Referring to Fig. 1 and Fig. 2, in some alternate embodiments, the solar cell 100 further includes second fine grids 30 and third fine grids 40 arranged on the cell substrate 10, wherein the second fine grids 30, the first fine grids 20 and the third fine grids 40 extend along the first direction and are disposed along the second direction, and the second fine grids 30 and the third fine grids 40 are adjacent to the first fine grids 20 in the second direction.

The first bending structures 60 include first bending sections 61 and second bending sections 62, wherein the first bending sections 61 are bent relative to the first fine grids 20 in a direction of being close to the second fine grids 30, and the second bending sections 62 are bent relative to the first fine grids 20 in a direction of being close to the third fine grids 40.

As such, the second fine grid 30 and the third fine grid 40 are respectively arranged on two sides of the first fine grid 20. One section close to the second fine grid 30 relative to the first fine grid 20 is the first bending section 61. One section close to the third fine grid 40 relative to the first fine grid 20 is the second bending section 62. Moreover, the first bending sections 61 and the second bending sections 62 can be connected alternately. In this way, the movement allowance of the first bending structures 60 in the plane of the cell substrate 10 can be improved without increasing the maximum bending distance in the second direction. Accordingly, the connection stability between the current collecting structures 50 and the first fine grids 20 is ensured.

In this embodiment, the second fine grids 30 and the third fine grids 40 may be respectively arranged on two sides of the first fine grids 20 and are adjacent to each other. the first bending structures 60 consist of first bending sections 61 and second bending sections 62, wherein the first bending sections 61 are bent relative to the first fine grids 20 in a direction of being close to the second fine grids 30, and the second bending sections 62 are bent relative to the first fine grids 20 in a direction of being close to the third fine grids 40. The first bending structures 60 are divided into the first bending sections 61 and the second bending sections 62, which can increase the bending length of the first bending structures 60 and avoid affecting further fine grids.

In one example, the first fine grids 20 are positive fine grids, while the second fine grids 30 and the third fine grids 40 are negative fine grids. In this way, the positive fine grids and the negative fine grids can be alternately arranged along the second direction. In addition, the first fine grids 20, the second fine grids 30 and the third fine grids 40 only define a relative position relationship. For example, referring to Fig. 1, the number of the first fine grids 20, the second fine grids 30 and the third fine grids 40 are all plural. In such a case, the second fine grid 30 is positioned on an upper side of the first first fine grid 20, a fine grid on a lower side of the first first fine grid 20 is the third fine grid 40, this fine grid is also the second fine grid 30 of the second first fine grid 20, and the like. In this way, a form of alternately arranging the positive fine grids and the negative fine grids is formed.

### Embodiment 5

Referring to Fig. 1 and Fig. 2, in some alternate embodiments, the maximum bending distance of the first bending structures 61 relative to the first fine grids 20 in the second direction is less than the distance between the first fine grids 20 and the second fine grids 30.

A maximum bending distance of the second bending structures 62 relative to the first fine grids 20 in the second direction is less than a distance between the first fine grids 20 and the third fine grids 40.

As such, the first bending structures 60 are connected between the first fine grids 20 and the current collecting structures 50. Moreover, maximum bending distances of the first bending sections 61 and the second bending sections 62 are less than distances from further fine grids, which can prevent the first bending sections 61 and the second bending sections 62 from being short-connected to the further fine grids and improve the connection stability between the first fine grids 20 and the current collecting structures 50.

Particularly, the maximum bending distance of the first bending structures 61 relative to the first fine grids 20 in the second direction is less than the distance between the first fine grid 20 and the second fine grid 30. The maximum bending distance of the second bending sections 62 relative to the first fine grids 20 in the second direction is less than the distance between the first fine grids 20 and the third fine grids 40. In this way, not only is the possibility of short-connecting the bending sections to the further fine grids avoided, but also the connection stability between the first fine grids 20 and the current collecting structures 50 is improved, and a range of the movement allowance of the current collecting structures 50 is increased, which is conducive to improving the structural reliability and electrical conductivity of the whole cell plate.

Certainly, in further embodiments, an insulation paste can be provided between the first bending structures 60 and the second fine grids 30. An insulation paste can be provided between the first bending structures 60 and the third fine grids 40 as well. In this way, the first fine grids 20 can be prevented from being short-connected to the further fine grids via the first bending structures 60.

### Embodiment 6

Referring to Fig. 1 and Fig. 2, in some alternate embodiments, a plurality of first bending structures 61 and a plurality of second bending sections 62 are disposed alternately along the first direction.

As such, the plurality of first bending sections 61 and the plurality of second bending sections 62 are alternately arranged along the first direction, which increases the movement allowance of the current collecting structures 50 while avoiding short-connecting to the further fine grids, and further ensures the connection stability between the first fine grids 20 and the current collecting structures 50.

Exemplarily, the numbers of the first bending sections 61 and the second bending sections 62 are both two. In a process of making the first fine grids 20 approach the current collecting structures 50, the first first bending section 61 is connected to the first second bending section 62, the first second bending section 62 is then connected to the second first bending section 61, the second first bending section 61 is then connected to the second second bending section 62, and the second second bending section 62 is finally connected to the current collecting structure 50. In this way, the plurality of first bending sections 61 and second bending sections 62 are alternately distributed in the first direction, which not only significantly increases the movement allowance of the current collecting structures 50 in the plane of the cell substrate 10, but also effectively disperses the stresses during soldering and heat treatment. Such an alternate arrangement manner further improves the connection stability between the first fine grids 20 and the current collecting structures 50, ensures the durability and conductivity of the cell plate in actual use, reduces the breaking risk caused by the stress concentration, and improves the overall reliability and service life of the solar cell 100.

### Embodiment 7

Referring to Fig. 1 and Fig. 2, in some alternate embodiments, the first bending structures 60 are undulated.

As such, the first bending structures 60 can be bent vertically in an undulated shape, which improves the movement allowance of the current collecting structures 50 without increasing the maximum bending distance, and further ensures the connection stability between the first fine grids 20 and the current collecting structures 50.

Particularly, the first bending structures 60 are undulated, that is to say, joints between the first bending sections 61 and the second bending sections 62 can be arranged in a rounded corner. In this way, the problem of the stress concentration caused by a sudden change in the joints between of the first bending sections 61 and the second bending sections 62 is avoided.

Further, the first bending sections 61 and the second bending sections 62 themselves are arc-shaped, which significantly increases the movement allowance of the current collecting structures 50 without increasing the maximum bending distance. Such an undulated structure can better buffer a stress change occurring during the soldering and the heat treatment and avoid the disconnection between the first bending sections 61 and the second bending sections 62 or the breaking of the first bending sections 61 and the second bending sections 62, thereby effectively ensuring the connection stability between the first fine grids 20 and the current collecting structures 50.

### Embodiment 8

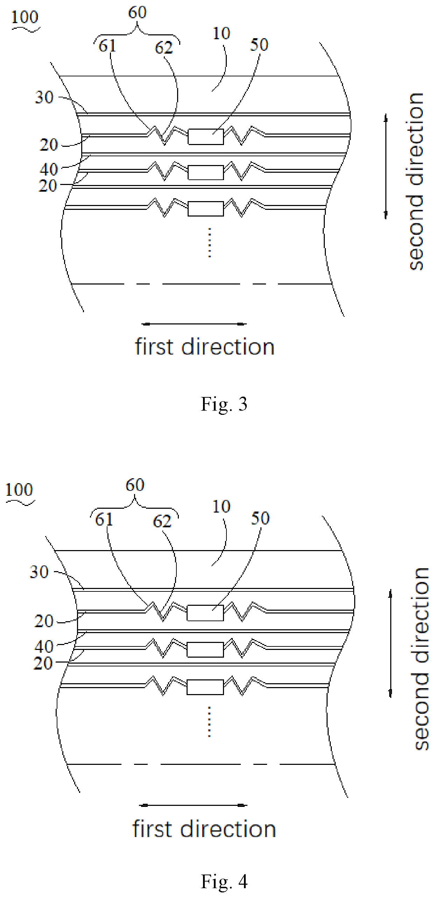

Referring to Fig. 3 and Fig. 4, in some alternate embodiments, the solar cell 100 further includes busbars 70 disposed on the cell substrate 10, wherein the current collecting structures 50 are formed on the busbars 70, and the plurality of busbars 70 extend along the second direction and are distributed along the first direction.

The first fine grids 20 are connected to the busbars 70 or the current collecting structures 50.

The second fine grids 30 and the third fine grids 40 are disconnected at the busbars 50.

As such, the first fine grids 20 can be connected to the busbars 70 via the first bending structures 60 and the current collecting structures 50, so as to conduct the collected electric currents to an external load via the busbars 70 and the solder strips and further generate the electricity,

Particularly, the second fine grids 30 and the third fine grids 40 have the same polarity, so as to be disconnected at the busbars to avoid being short-connected to the busbars 70. The busbars 70 can be connected to the plurality of first fine grids 20 and collect electric currents on the plurality of first fine grids 20, while the current collecting structures 50 are formed on the busbars 70. A part of the first fine grids 20 can be connected to the current collecting structures 50 via the first bending structures 60. Accordingly, the electric currents of all the first fine grids 20 are collected on the busbars 70. The solder strips can be connected to the current collecting structures 50 in a soldering manner, and extend along a direction of the busbars 70. Accordingly, the electric currents on the busbars 70 are conducted to the external load.

It should be understood that there is a further busbar connected to the second fine grids 30 and the third fine grids 40, the first fine grids 20 are disconnected at joints between the further busbar and the second fine grids 30 and the third fine grids 40, and the busbar can be provided with further current collecting members and solder strips. In addition, in embodiments of the present disclosure, the current collecting structures 50 have no constraints on their shapes to meet different needs.

Certainly, in some embodiments, the second fine grids 30 and the third fine grids 40 have the same polarity, the first fine grids 20 and the busbars 70 have the same polarity, and the insulation paste can be arranged between the second fine grids 30 and the third fine grids 40 and the busbars 70. In this way, the problem of short circuit is avoided.

### Embodiment 9

Referring to Fig. 3 and Fig. 4, in some alternate embodiments, the solar cell 100 further includes second bending structures 80, wherein the second bending structures 80 are connected to the busbars 70 and the current collecting structures 50, and the second bending structures 80 extend along the second direction and are at least partially bent in the first direction.

As such, the busbars 70 are connected to the current collecting structures 50 via the second bending structures 80, such that the current collecting structures 50 have a certain movement allowance in the plane of the cell substrate 10. The second bending structures 80 can change elastically when the solder strips are connected to the current collecting structures 50, which ensures the connection stability. Moreover, a width of portions where the second bending structures 80 are in contact with the current collecting structures 50 in the first direction is greater than that of the busbars 70 in the first direction, which further improves the connection stability and prevent the busbars 70 from being broken due to the stress concentration.

In this embodiment, the second bending structures 80 are formed between the busbars 70 and the current collecting structures 50, which further increases the movement allowance of the current collecting structures 50 in the plane of the cell substrate 10. That is to say, when the current collecting structures 50 move slightly relative to the cell substrate 10, the second bending structures 80 can be pulled to change elastically to move slightly, so as to avoid the disconnection between the busbars 70 and the current collecting structures 50 in a fabricating process and improve the connection stability.

Further, in the first direction, a width of the current collecting structures 50 is greater than that of the second bending structures 80 and the busbars 70. The second bending structures 80 are bent horizontally relative to the busbars 70 in the first direction. That is to say, the second bending structures 80 have a certain gradient relative to the busbars 70. In this way, the width of the portions where the current collecting structures 50 are in contact with the second bending structures 80 in the first direction is greater than that of the busbars 70 in the first direction. The second bending structures 80 and the current collecting structures 50 have a large connection area, which can improve the connection stability between the second bending structures 80 and the current collecting structures 50, eliminate the problem of the stress concentration, and prevent the busbars 70 from being broken due to the stress concentration.

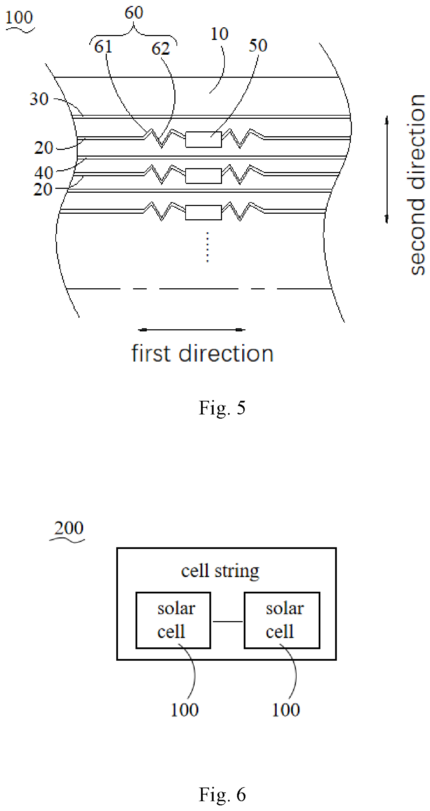

Referring to Fig. 5, in some embodiments, the second bending structures 80 are undulated.

In addition, in embodiments of the present disclosure, a correspondence relationship between the busbars 70 and the second bending structures 80 is not defined so as to meet different needs. In some embodiments, the second bending structures 80 may be selectively arranged at ends of a part of the busbars 70, and no second bending structures 80 are arranged at ends of the other part of the busbars 70. In further embodiments, one ends of the busbars 70 can be provided with the second bending structures 80 while the other ends thereof can be provided with no second bending structures 80. In further embodiments, two ends of each of the busbars 70 can be provided with the second bending structures 80.

### Embodiment 10

Referring to Fig. 3 and Fig. 5, in some alternate embodiments, the second bending structures 80 have a maximum bending distance of 100µm to 400µm relative to the busbars 70 in the first direction.

The second bending structures 80 have a height of 35µm to 200µm in the third direction, wherein the third direction is perpendicular to the first direction and the second direction.

As such, the maximum bending distance of the second bending structures 80 relative to the busbars 70 in the first direction is set within such a range, which can ensure that the current collecting structures 50 have a movement allowance, and prevent the current collecting structures 50 from being disconnected from the first bending structures 80 and the second bending structures 80from influencing the further fine grids. Moreover, the height of the second bending structures 80 relative to the cell substrate 10 in the third direction is set within such a range, which can ensure the connection stability between the busbars 70 and the current collecting structures 50, and avoid affecting the thickness of the cell module 300 due to large height of the second bending structures 80.

For example, the maximum bending distance of the second bending structures 80 relative to the busbars 70 in the first direction can be 100µm, 110µm, 120µm, 130µm, 140µm, 150µm, 160µm, 170µm, 180µm, 190µm, 200µm, 210µm, 220µm, 230µm, 240µm, 250µm, 260µm, 270µm, 280µm, 290µm, 300µm, 310µm, 320µm, 330µm, 340µm, 350µm, 360µm, 370µm, 380µm, 390µm, 400µm.

For another example, the height of the second bending structures 80 in the third direction can be 35µm, 40µm, 50µm, 60µm, 70µm, 80µm, 90µm, 100µm, 110µm, 120µm, 130µm, 140µm, 150µm, 160µm, 170µm, 180µm, 190µm, 200µm.

Exemplarily, the maximum bending distance of the second bending structures 80 relative to the busbars 70 in the first direction can be 300µm. Moreover, the height of the second bending structures 80 in the third direction can be 100µm. In this way, it is possible to ensure that the current collecting structures 50 have a sufficient movement allowance in the plane of the cell substrate 10. Accordingly, the problem that the current collecting structures 50 are disconnected from the second bending structures 80 due to the stress concentration is avoided. In addition, the proper control of the bending distance can prevent the second bending structures 80 from interfering with or affecting the normal function of the further fine grids or the busbars. Moreover, the height of the second bending structures 80 in the third direction is controlled within a reasonable range, which can not only ensure the connection stability between the busbars 70 and the current collecting structures 50, but also avoid affecting the overall thickness and structural integrity of the cell module 300 due to large height of the bending structures.

### Embodiment 11

Referring to Fig. 1 and Fig. 6, a cell string provided in an embodiment of the present disclosure includes the solar cell 100 as described in any of the above embodiments.

In the solar cell 100 and the cell string 200 according to embodiments of the present disclosure, the solar cell 100 includes the cell substrate 10, the first fine grids 20, the second fine grids 30, the current collecting structures 50 and the first bending structures 60. The first fine grids 20 are disposed on the cell substrate 10 and extend along the first direction. The second fine grids 30 are disposed on the cell substrate 10. The first fine grids 20 and the second fine grids 30 are disposed along the second direction. The current collecting structures 50 are disposed on the cell substrate 10. The first fine grids 20 are at least partially connected to the current collecting structures 50. The first bending structures 60 are connected to the first fine grids 20 and the current collecting structures 50. The first bending structures 60 extend along the first direction and are at least partially bent in the second direction. The width of the portions where the current collecting structures 50 are in contact with the first bending structures 60 in the second direction is greater than that of the first fine grids 20 in the second direction. As such, the first fine grids 20 are connected to the current collecting structures 50 via the first bending structures 60, such that the current collecting structures 50 have a certain movement allowance in a plane of the cell substrate 10. The first bending structures 60 can change elastically when solder strips are connected to the current collecting structures 50, so as to ensure the connection stability. Moreover, the width of the portions where the first bending structures 60 are in contact with the current collecting structures 50 in the second direction is greater than that of the first fine grids 20 in the second direction, which further improves the connection stability and prevent the first fine grids 20 from being broken due to the stress concentration.

It should be understood that in the cell string 200, the cell string 200 may include two cell plates connected in series, three cell plates connected in series or further more cell plates. Particularly, the number of the cell plates required to be connected in series can be determined according to the actual usage. In addition, in embodiments of the present disclosure, sizes and types of the cell plates have no constraints, and specifications and sizes of adjacent cell plates may be the same or different to meet different needs.

### Embodiment 12

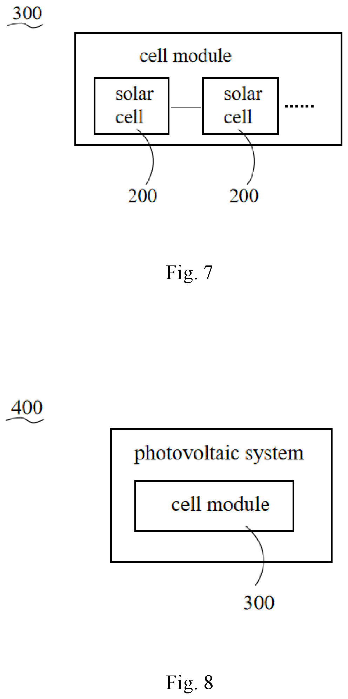

Referring to Fig. 1 and Fig. 7, a cell module 300 provided in an embodiment of the present disclosure includes the cell string 200 as described in the above embodiments.

In the solar cell 100, the cell string 200 and the cell module 300 according to embodiments of the present disclosure, the solar cell 100 includes the cell substrate 10, the first fine grids 20, the second fine grids 30, the current collecting structures 50 and the first bending structures 60. The first fine grids 20 are disposed on the cell substrate 10 and extend along the first direction. The second fine grids 30 are disposed on the cell substrate 10. The first fine grids 20 and the second fine grids 30 are disposed along the second direction. The current collecting structures 50 are disposed on the cell substrate 10. The first fine grids 20 are at least partially connected to the current collecting structures 50. The first bending structures 60 are connected to the first fine grids 20 and the current collecting structures 50. The first bending structures 60 extend along the first direction and are at least partially bent in the second direction. The width of the portions where the current collecting structures 50 are in contact with the first bending structures 60 in the second direction is greater than that of the first fine grids 20 in the second direction. As such, the first fine grids 20 are connected to the current collecting structures 50 via the first bending structures 60, such that the current collecting structures 50 have a certain movement allowance in a plane of the cell substrate 10. The first bending structures 60 can change elastically when solder strips are connected to the current collecting structures 50, so as to ensure the connection stability. Moreover, the width of the portions where the first bending structures 60 are in contact with the current collecting structures 50 in the second direction is greater than that of the first fine grids 20 in the second direction, which further improves the connection stability and prevent the first fine grids 20 from being broken due to the stress concentration.

It should be understood that in such an embodiment, the cell module 300 may further include a frame, a backboard, photovoltaic glass and an adhesive film. The adhesive film can be filled among the front and the back of the cell substrate 10 and the photovoltaic glass, adjacent cell plates and the like as a filler, and can be a transparent adhesive with good light transmittance and aging resistance. For example, an EVA adhesive film or a POE adhesive film can act as the adhesive film, which can be selected according to an actual situation, and will not limited herein.

The photovoltaic glass can be covered on the adhesive film on the front of the cell substrate 10. The photovoltaic glass can be ultra-clear glass which has high light transmittance, high transparency, and excellent physical, mechanical and optical properties. For example, the light transmittance of the ultra-clear glass can reach more than 92%, such that the ultra-clear glass can protect the cell plate without affecting the efficiency of the cell plate as much as possible. Moreover, the adhesive film can adhere the photovoltaic glass and the cell plate together, and the adhesive film can be used to seal, insulate and protect the cell plate from being influenced by water or moisture.

The backboard can be attached to the adhesive film on the back of the cell substrate 10. The backboard can protect and support the cell plate, and has reliable insulation, water resistance and aging resistance. In general, the backboard can have multiple forms, such as tempered glass, organic glass, an aluminum alloy TPT composite adhesive film and the like, which can be set according to a specific situation and will not limited herein. An assembly composed of the backboard, the cell plate, the adhesive film and the photovoltaic glass can be arranged on the frame. The frame serves as a main external supporting structure of the whole cell module 300, and can provide stable support and installation of the cell module 300. For example, the cell module 300 can be installed at a required position through the frame.

### Embodiment 13

Referring to Fig. 1 and Fig. 8, a photovoltaic system 400 provided in an embodiment of the present disclosure includes the cell module 300 as described in the above embodiments.

In the solar cell 100, the cell string 200, the cell module 300 and the photovoltaic system 400 according to embodiments of the present disclosure, the solar cell 100 includes the cell substrate 10, the first fine grids 20, the second fine grids 30, the current collecting structures 50 and the first bending structures 60. The first fine grids 20 are disposed on the cell substrate 10 and extend along the first direction. The second fine grids 30 are disposed on the cell substrate 10. The first fine grids 20 and the second fine grids 30 are disposed along the second direction. The current collecting structures 50 are disposed on the cell substrate 10. The first fine grids 20 are at least partially connected to the current collecting structures 50. The first bending structures 60 are connected to the first fine grids 20 and the current collecting structures 50. The first bending structures 60 extend along the first direction and are at least partially bent in the second direction. The width of the portions where the current collecting structures 50 are in contact with the first bending structures 60 in the second direction is greater than that of the first fine grids 20 in the second direction. As such, the first fine grids 20 are connected to the current collecting structures 50 via the first bending structures 60, such that the current collecting structures 50 have a certain movement allowance in a plane of the cell substrate 10. The first bending structures 60 can change elastically when solder strips are connected to the current collecting structures 50, so as to ensure the connection stability. Moreover, the width of the portions where the first bending structures 60 are in contact with the current collecting structures 50 in the second direction is greater than that of the first fine grids 20 in the second direction, which further improves the connection stability and prevent the first fine grids 20 from being broken due to the stress concentration.

In this embodiment, the photovoltaic system 400 can be applied in a photovoltaic power station, such as an above-ground power station, a rooftop power station, a floating power station, and the like, and can further be applied to a device or apparatus utilizing solar energy to generate electricity, such as a solar power source of a user, a solar street lamp, a solar car and a solar building. Certainly, it should be understood that an application scenario of a photovoltaic System 400 are not limited to this, that is to say, the photovoltaic system 400 can be applied in all fields that require the use of solar energy for power generation. Considering a photovoltaic power generation system network as an example, the photovoltaic system 400 can include a photovoltaic array, a combiner box and an inverter. The photovoltaic array can be an array combination of a plurality of cell modules 300. For example, the plurality of cell modules 300 can form a plurality of photovoltaic arrays. The photovoltaic arrays are connected to the combiner boxes. The combiner boxes can be configured to collect electric currents generated by the photovoltaic arrays. The collected electric currents are converted into alternating currents required by a mains power grid via the inverter and then connected to the mains power grid to realize the solar power supply.

In the description of this specification, reference terms such as "one embodiment", "exemplary embodiments", "examples", "specific examples" or "some examples" mean that particular features, structures, materials or features described in conjunction with embodiments or examples described are included in at least one embodiment or example of the present disclosure. In this specification, schematic representations of the above terms do not necessarily refer to the same embodiments or example. Furthermore, the particular features, structures, materials, or features described may be combined in any one or more embodiments or examples in a proper manner.

In addition, the above embodiments are preferred embodiments of the present disclosure, and are not intended to limit the present disclosure. Any modifications, modifications, equivalent substitutions or improvements made within the spirit and principles of the present disclosure should be included within the scope of protection of the present disclosure.

## Claims

1. A solar cell, comprising:
a cell substrate;
first fine grids disposed on the cell substrate, wherein the first fine grids extend along a first direction;
second fine grids disposed on the cell substrate, wherein the first fine grids and the second fine grids are distributed along a second direction;
current collecting structures disposed on the cell substrate, wherein the first fine grids are at least partially connected to the current collecting structures; and
first bending structures, connected to the first fine grids and the current collecting structures, wherein the first bending structures extend along the first direction and are at least partially bent in the second direction, and a width of portions where the current collecting structures are in contact with the first bending structures in the second direction is greater than the width of the first fine grids in the second direction.

2. The solar cell according to claim 1, wherein the first bending structures have a maximum bending distance of 100µm to 400µm relative to the first fine grids in the second direction.

3. The solar cell according to claim 1, wherein the first bending structures have a height of 35µm to 200µm in a third direction, wherein the third direction is perpendicular to the first direction and the second direction.

4. The solar cell according to claim 1, further comprising second fine grids and third fine grids arranged on the cell substrate, wherein the second fine grids, the first fine grids and the third fine grids extend along the first direction and are distributed along the second direction, and the second fine grids and the third fine grids are adjacent to the first fine grids in the second direction; and
the first bending structures comprise first bending sections and second bending sections, wherein the first bending sections are bent relative to the first fine grids in a direction of being close to the second fine grids, and the second bending sections are bent relative to the first fine grids in a direction of being close to the third fine grids.

5. The solar cell according to claim 4, wherein the maximum bending distance of the first bending structures relative to the first fine grids in the second direction is less than a distance between the first fine grids and the second fine grids; and
a maximum bending distance of the second bending structures relative to the first fine grids in the second direction is less than a distance between the first fine grids and the third fine grids.

6. The solar cell according to claim 4, wherein a plurality of the first bending structures and a plurality of the second bending sections are disposed alternately along the first direction.

7. The solar cell according to claim 4, wherein the first bending structures are undulated.

8. The solar cell according to claim 4, further comprising busbars disposed on the cell substrate, wherein the current collecting structures are formed on the busbars, and a plurality of the busbars extend along the second direction and are distributed along the second direction; and
the first fine grids are connected to the busbars or the current collecting structures; and
the second fine grids and the third fine grids are disconnected at the busbars.

9. The solar cell according to claim 8, further comprising second bending structures, wherein the second bending structures are connected to the busbars and the current collecting structures, and the second bending structures extend along the second direction and are at least partially bent in the first direction.

10. The solar cell according to claim 9, wherein the second bending structures have a maximum bending distance of 100µm to 400µm relative to the busbars in the first direction; and
the second bending structures have a height of 35µm to 200µm in a third direction, wherein the third direction is perpendicular to the first direction and the second direction.

11. A cell string, comprising the solar cell according to any one of claims 1 to 10.

12. A cell module, comprising the cell string according to claim 11.

13. A photovoltaic system, comprising the cell module according to claim 12.
